Europäisches Patentamt

European Patent Office

Office européen des brevets

(19)

(11) Publication number: **0 030 457**
**B1**

(12) **EUROPEAN PATENT SPECIFICATION**

(45) Date of publication of patent specification: **11.07.84**

(51) Int. Cl.³: **H 01 L 21/322**

(21) Application number: **80304373.6**

(22) Date of filing: **04.12.80**

(54) Method of manufacturing a silicon wafer with interior microdefects capable of gettering.

(30) Priority: **05.12.79 JP 157576/79**

(43) Date of publication of application:
**17.06.81 Bulletin 81/24**

(45) Publication of the grant of the patent:
**11.07.84 Bulletin 84/28**

(84) Designated Contracting States:
**DE FR GB**

(56) References cited:
**GB - A - 1 349 574**

**Patents Abstracts of Japan Vol. 2, No. 53, 17 April 1978, page 1032E78
Patents Abstracts of Japan Vol. 2, No. 56, 24 April 1978, page 1413E78
JOURNAL OF APPLIED PHYSICS, Vol. 50, No. 12, December 1979 New York S. KISHINO et al. "Heat-Treatment Behavior of Microdefects and Residual Impurities in CZ Silicon Crystals pages 8240 to 8243**

(73) Proprietor: **VLSI Technology Research Association
4-28, Mita 1-chome Minato-ku
Tokyo 108 (JP)**

(72) Inventor: **Nagasawa, Kazutoshi
4-12-19, Sakawa Odawara-shi
Kanagawa, 256 (JP)**
Inventor: **Kishino, Seigo
881-7, Narahara-cho Hachioji-shi
Tokyo 193 (JP)**
Inventor: **Matsushita, Yoshiaki
1-35-13, Okamoto Setagaya-ku
Tokyo, 157 (JP)**
Inventor: **Kanamori, Masaru
c/o Nippon Electric Company Limited 33-1, Shiba
5-chome, Minato-ku Tokyo 108 (JP)**

(74) Representative: **Bedggood, Guy Stuart et al,
Haseltine Lake & Co. Hazlitt House 28
Southampton Buildings Chancery Lane
London WC2A 1AT (GB)**

Courier Press, Leamington Spa, England.

# 0 030 457

(56) Referencee cited:

IBM TECHNICAL DISCLOSURE BULLETIN, Vol. 20, Nr. 2 July 1977 New York S.M. HU "Optimum Reprocessing Heat Treatment for Lifetime Improvement page 587

APPLIED PHYSICS LETTERS, Vol. 30, Nr. 1, 1 January 1977 New York P.E. FREELAND et al. "Precipitation of Oxygen in Silicon" pages 31 to 33

APPLIED PHYSICS LETTERS, Vol. 37, No. 5, 1 September 1980 New York F. SHIMURA et al. "Precipitation and Redistributation of Oxygen in Czochralski-Grown Silicon" pages 483 to 486

## Description

The present invention relates to a method of forming a silicon wafer with interior microdefects capable of gettering according to the first part of claim 1. Such a method is known from Patent Abstracts of Japan, Vol. 2, No. 53, 17. April 1978, p. 1032 E78 Kokai Nr. 53-15764.

In the manufacture of a semiconductor device such as an integrated circuit (IC), a large scale integration (LSI) device and so forth, defects brought about in processes for fabrication of the semi-conductor device and detrimental impurities which were present in a semiconductor wafer or which were mixed into the semiconductor wafer have been found to exert adverse effects on device characteristics or parameters such as leakage currents, breakdown voltages, gain and so forth. Such defects and impurities cannot only shorten the lifetime of the device, but can also have very serious and adverse effects on the device parameters in the process of diffusion of impurities, by causing spike diffusions, for example.

In order to prevent occurrence of such defects or to eliminate detrimental impurities, various gettering methods have been introduced into processes for fabrication of semiconductor wafers, for example a method involving roughening the back side of a semiconductor wafer by sand blasting or gettering effect by implantation of ions into the back side of a semiconductor wafer, or oxidization by hydrogen chloride. Recently, an intrinsic gettering method has been reported in which crystalline defects are created within or inside a semiconductor wafer for the purpose of utilising the defects as a sink for gettering.

It has come to be known, however, that these methods of gettering exhibit some defects when applied to the manufacture of semiconductor devices, although they certainly have exhibited several remarkable merits. For example, the method involving intentionally damaging the reverse side or back side of a semiconductor wafer by sand blasting suffers from the fact that the front side of the semiconductor wafer is liable to scratches and contamination. The method involving implantation of ions into the back side of a semiconductor wafer cannot escape from the same defects as are experienced in the sand blasting method. The method of oxidising by means of hydrogen chloride not only involves a lengthy gettering process but also has a weakness in that a semiconductor wafer can be warped in the process.

In the intrinsic gettering mentioned above, defects are created in the interior of a semiconductor wafer, and a region devoid of defects, the so-called denuded zone, is formed on the surface of the semiconductor wafer. To achieved this purpose, two methods have been proposed. In the first method, the semiconductor wafer is annealed at a temperature higher than 1000°C in non-oxidising atmosphere.

In Japanese Patent Application No. 89111 of 1976 (Filing Date: 28 July 1976) which was published without examination on 14 February 1978 under Publication No. 15764/1978, there is disclosed a gettering method involving the fabrication of an oxide layer on an epitaxial layer grown on the front side of a silicon semiconductor substrate. For the purpose of gettering, the silicon semiconductor substrate is first annealed, in nonoxidising atmosphere, for one (1) to 20 hours at a temperature higher than 1,000°C. For example, the substrate is annealed in a nitrogen atmosphere or in vacuum for two (2) hours at 1,200°C. The surface layers in a range of 0.1 to 10 $\mu$m depth of the semiconductor substrate are then removed by etching, for example, and an oxidising process is then carried out at 1,000°C in wet oxygen atmosphere.

Japanese Patent Application No. 94878 of 1976 (Filing Date: 11 August 1976), published without examination on 25 February 1978 under Publication No. 20862/1978 discloses another gettering method wherein a semiconductor substrate on which an epitaxial layer has been grown is first heat treated at a temperature in the range 1,000 to 1,200°C for forming an oxide layer, then it is annealed in a non-oxidising atmosphere for four (4) to 30 hours at a temperature in the range 1,000 to 1,250°C. Thereafter, surface layers in the range 10 to 50 or 60 $\mu$m depth of the semiconductor substrate are removed.

In a second method, a silicon semiconductor wafer is first annealed in an oxidising atmosphere at a low temperature below 800°C, then the semiconductor wafer is annealed in non-oxidising atmosphere at a high temperature, above 1,000°C.

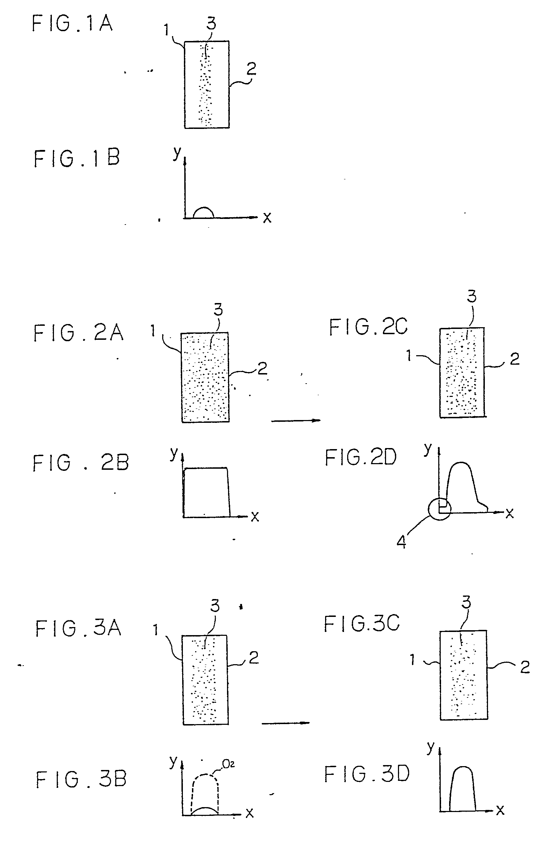

In order to create defects in the interior of the wafer according to the first method, the wafer must be such that, when heat treated, oxygen in the crystal may be precipitated. However, with so-called CZ wafers made by the Czochralski method currently on the market, it has been found that, although they contain a considerable amount of oxygen, oxygen is hardly precipitated. Because of this, it is difficult to create defects in the silicon crystal according to the method as illustrated in Figure 1A of the accompanying drawings to effect gettering. In Figure 1A, which shows a silicon wafer in cross-section, defects 3 are shown in the interior of the wafer between a front side 1 and back side 2 of the silicon wafer. Figure 1B of the accompanying drawings is a graphical illustration of the defect density (ordinate) relative to the depth into the silicon wafer (abscissa).

In the second method mentioned above, microdefects are created as illustrated in Figures 2A and 2B of the accompanying drawings by the first annealing at low temperature, then by the subsequent higher temperature annealing defects capable of gettering are created in the interior of the silicon wafer and denuded zones are formed on the surfaces of the silicon wafer as illustrated in Figures 2C and 2D of the accompanying drawings. Figures 2A and 2C are views similar to that of Figure 1A, and Figures 2B and 2D are graphical illustrations similar to that of Figure 1B, with the same reference numerals referring to the same parts. The second method is effective in overcoming the problem experienced in the first method — the difficulty of creating microdefects capable of gettering by a single heat treatment. However, as illustrated in Figure 2D, part 4 having microdefects which were created near the surface by annealing at low temperature cannot be completely eliminated by subsequent annealing at high temperature, so that microdefects turn out to be macro-defects in subsequent processes such as a diffusion process, etc. It has been found that part 4 is very difficult to eliminate and the part 4 remains even if heat treatment is carried out for many hours. It was also found that defect density in the interior of the silicon wafer would become low if heat treatment were prolonged in order to eliminate part 4 completely. It is to be understood that conditions for heat treatment are difficult to select because whether or not the part 4 can be successfully eliminated depends upon the crystalline properties of the silicon wafer.

From Patent Abstracts of Japan, Vol. 2, No. 53, 17 April 1978, page 1032 E78 Kokai Nr. 53-15764, it is known that first heat treating at 1000°C or more, causes a denuded zone free of microdefects in a silicon wafer near the surface by outdiffusing oxygen. From Applied Physics Letters Vol. 30, No. 1, January 1977, pages 31—33, it is known that a preliminary heat treating at 700°C prior to a heat treating at 1200°C, causes defects in a silicon wafer by creating nucleation of oxygen precipitates.

According to the present invention there is provided a method of forming a silicon wafer with interior microdefects capable of gettering, comprising heat treating the wafer in two different temperature ranges, the heat treating in a first of those ranges being carried out in a non-oxidising atmosphere, to form a denuded zone free of microdefects in a surface layer of the wafer and the heat treating in the second of those ranges being carried out to form in the interior of the wafer microdefects capable of gettering, characterised by, the first temperature range having the limits 950°C and 1300°C, the heat treating of the wafer in the first temperature range diffusing oxygen out of the surface layer of the wafer, and

the second temperature range having the limits 600°C and 800°C, the subsequent heat treating of the wafer in the second temperature range creating nucleation of oxygen precipitates.

An embodiment of the present invention can provide, without relying on the quality of a silicon wafer as described above, a method for forming denuded zones, devoid of microdefects, near the surfaces of the wafer while creating in the interior of the wafer such defects as would perform a gettering function.

Thus, in an embodiment of the present invention a silicon wafer is first treated at a high temperature in non-oxidising atmosphere, then, secondly, heat treated at a temperature lower than the first mentioned temperature.

In the present invention, the silicon wafer is annealed at a temperature of 950°C—1,300°C in a non-oxidising atmosphere for more than 10 minutes but preferably less than 70 hours to bring about diffusion out of oxygen near the surfaces of the wafer. Then, the wafer is annealed at a temperature in the range 600°C to 800°C to have microdefects created in the interior of the wafer. Where the wafer is subsequently heat treated, microdefects of a high density capable of gettering grow in the interior of the wafer to be microdefects of comparatively larger size. Near the surfaces, microdefects such as stacking defects are not created because oxygen density is low.

Reference is made, by way of example, to the accompanying drawings, in which:—

Figures 1A, 2A and 2C are respective cross-sectional views of wafers illustrating conventional intrinsic gettering methods, and Figures 1B, 2B and 2D are respective graphs showing relationships between defect density and depth into a wafer, for such conventional gettering methods,

Figures 3A and 3C are respective cross-sectional views of silicon wafers for assistance in explanation of a method embodying the present invention, and Figures 3B and 3D are respective graphs illustrating defect density versus depth in the wafers as shown in Figures 3A and 3C respectively, and

Figures 4 and 5 are graphs for assistance in illustrating the relationship between interstitial oxygen content and annealing time in a silicon wafer manufactured according to the present invention.

In a method embodying the present invention, a silicon wafer is annealed in non-oxidising atmosphere at temperature in the range 950°C to 1,300°C for more than ten minutes but preferably less than 70 hours to diffuse out oxygen from near the surfaces of the wafer. The silicon wafer thus treated is illustrated in Figure 3A which is a cross-sectional view of the silicon wafer, and in Figure 3B in which the ordinate represents defect density in relation to the solid line in the Figure and oxygen content in relation to the broken line, and the abscissa represents depth into the silicon wafer.

The silicon wafer is next annealed at temperature in the range 600°C to 800°C to create microdefects of high density. The silicon wafer after such heat treatment is illustrated in Figures 3C and 3D.

When the silicon wafer is subjected to subsequent processes for heat treatment of silicon, microdefects of high density in the interior of the silicon wafer grow to become macrodefects capable of gettering, whilst near the surfaces of the silicon wafer, microdefects such as stacking defects are not created because oxygen content is low. By carrying out this simple and effective method of gettering, not only is there a reduction in undesired defects brought about by manufacturing processes, but the creation of stacking defects as a result of ion implantation may also be suppressed. Further, detrimental impurities that are mixed into the wafer during processing of the wafer are subjects for gettering. As a result, electric characteristics such as lifetime etc. are improved, and with improvement in various electric characteristics of a semiconductor device yield is increased.

In a method embodying the present invention, the first heat treatment is carried out at a temperature in the range 950°C to 1,300°C. At temperatures lower than 950°C, it has been confirmed that diffusion of oxygen out from the surfaces of the silicon wafer is decreased, and creation of defects becomes difficult, so that little effect is produced. On the other hand, at temperatures higher than 1,300°C, it was found that the nature of the cooling process has a significant effect rendering it difficult to obtain stable characteristics.

In a method embodying the present invention the second heat treatment is carried out at a temperature in the range 600°C to 800°C. At temperatures lower than 600°C, the size of a nucleus formed becomes small. In subsequent heat treatment at high temperature for fabrication of the device, the nucleus disappears and desired effects cannot be obtained. Further, at temperatures higher than 800°C, density of defects decreases. Unless big enough a nucleus does not grow, and the desired effects are reduced.

One embodiment of the invention will be described in more detail. A (100) silicon single crystal CZ wafer made by the Czochralski method is heat treated for four (4) hours at 1,050°C in a nitrogen atmosphere according to a conventional heat treatment technique. By such heat treatment, oxygen is diffused out from surface layers to a 10 $\mu$m depth into the silicon wafer. Next, the silicon wafer is heat treated for 16 hours at 650°C in an oxygen atmosphere, also in accordance with a conventional heat treatment technique, to provide a silicon wafer according to the invention. Next, a condition is established under which defects appear mostly at the front side of the crystal by heat treatment of the silicon wafer, that it, ions of boron are implanted into the front side of the silicon wafer by a conventional implantation technique, to a dosage of 3 × 10$^{14}$ cm$^{-2}$, at 75 KeV. Thereafter, using conventional techniques, heat treatment is effected at 1,050°C for four (4) hours in an non-oxidising atmosphere, followed by a oxidising process effected at 1,100°C for four (4) hours. After these processes, defects created at the surface of the wafer were examined as follows.

A test piece processed as described above was etched by those means which are known to the person skilled in the art, and the defects created at the surface of and in the interior of the test piece were observed by microscope and compared with those in a comparison test piece in respect of which the method of the present invention was not employed.

In the comparison silicon wafer test piece stacking defects of high density are created in a region where ions are implanted. In the silicon wafer test piece manufactured according to the present invention, creation of defects in a region where ions are implanted is scarcely observed.

Further, the silicon wafer test pieces were split along places of cleavage in order to investigate distribution of defects in the direction of depth thereof, etched using conventional techniques, and observed.

In the comparison test piece, defects created in the interior of the test piece were not many. With the test piece manufactured according to the present invention, denuded zones without defects were observed near the surface, with defects of high density created in the interior of the test piece.

It was thus confirmed that, in the comparison test piece, damage, impurities, etc. created by implantation of ions become nuclei of defects near the surface which defects appear in subsequent heating and oxidising processes whereas in the silicon wafer test piece manufactured according to the present invention, defects are not created at the surface, even if heating and oxidising processes are carried out, due to the low content of oxygen near the surface of the wafer and the gettering effect of the defects in the interior of the silicon wafer.

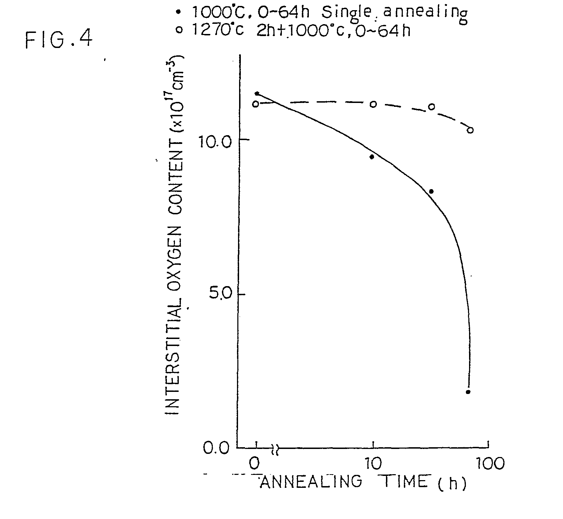

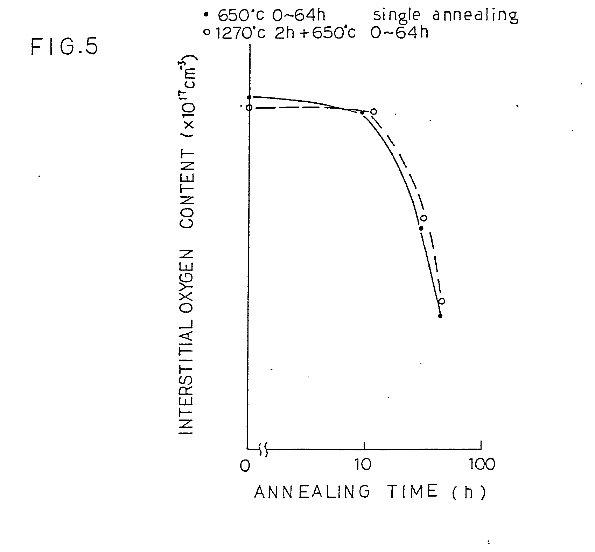

Figures 4 and 5 show graphs illustrating relationships between interstitial oxygen content and the annealing time which latter is shown on a logarithmic scale. Interstitial oxygen content illustrates the concentration of oxygen in a silicon crystal, and if the content is high fewer defects are created. The solid lines in Figures 4 and 5 represent results of single annealings at 1,000°C and 650°C respectively, and the broken lines represent results of a first annealing at 1,270°C for two (2) hours followed by second annealing at 1,000°C (Figure 4) and 650°C (Figure 5) for 16 hours, respectively. These results show that nucleation of oxygen precipitates occurs at temperatures around 650°C with and without high temperature preannealing. However, nucleation hardly occurs at all at temperatures around 1,000°C if a higher temperature preannealing is added. As a result, the nucleation occurs at temperatures around 650°C regardless of the crystalline quality of the starting silicon wafer. It should be noted, however, that results of annealing according to a method embodying the present invention do not depend considerably on the crystalline property of the silicon wafer processed.

As has been described, it is believed that a silicon wafer processed in accordance with an embodiment of the present invention has a merit in that undesired defects brought about by ion implantation, which are most likely to cause detrimental defects during fabrication of semiconductor devices, are effectively reduced, while heavy metals that are in the wafer or that mix into the wafer in fabrication processes can be expected to be gettered. Lifetime measured with a wafer processed with a gettering method as described above embodying the present invention was several times longer than that of a conventionally processed wafer.

Where a silicon wafer produced by means of the present invention is used, defect density may be substantially reduced even in processes liable to create defects such as ion implantation, heat treatment for oxidising purposes, etc. Heavy metals are gettered. Thus, reduction of leakage currents, longer lifetime, improvement of gain, etc. which contribute to improved characteristics and yield of semiconductor devices can be expected by employment of the invention.

Active elements and/or passive elements of a semiconductor device may be formed in the denuded zone at the surface of a silicon wafer processed according to the present invention. For this purpose a field oxide layer may be formed on the surface of the silicon wafer by conventional selective oxidation using silicon nitride as a mask. In such a selective oxidation process, a field oxide layer 800 mm (8000Å) thick is formed by heat treatment at 1100°C, for four (4) hours in a wet oxygen atmosphere. However the denuded zones and microdefects capable of gettering in the silicon wafer made according to the present invention are not changed in size or amount.

Alternatively, the active elements and/or passive elements of a semiconductor device may be formed on a silicon epitaxial layer which is formed on the surface of a silicon wafer made according to the present invention. In this case, characteristics of the epitaxial layer and electrical characteristics of the active elements and/or passive elements are improved. During an epitaxial growth process, the epitaxial layer is grown by heat treatment at 1100°C to 1200°C in a hydrogen atmosphere, for example. However, the denuded zones and the microdefects capable of gettering in the silicon wafer made according to the present invention are not changed in size or amount.

## Claims

1. A method of forming a silicon wafer with interior microdefects capable of gettering, comprising heat treating the wafer in two different temperature ranges, the heat treating in a first of those ranges being carried out in a non-oxidising atmosphere, to form a denuded zone free of microdefects in a surface layer of the wafer, and the heat treating in the second of those ranges being carried out to form in the interior of the wafer microdefects capable of gettering, characterised by, the first temperature range having the limits 950°C and 1300°C, the heat treating of the wafer in the first temperature range diffusing oxygen out of the surface layer of the wafer, and

the second temperature range having the limits 600°C and 800°C, the subsequent heat treating of the wafer in the second temperature range creating nucleation of oxygen precipitates.

2. A method as claimed in claim 1, wherein the heat treating of the wafer in the first temperature range lasts for 10 minutes or more.

3. A method as claimed in claim 1 or 2, wherein the heat treating of the wafer in the first temperature range lasts for less than 70 hours.

4. A method as claimed in claim 1, 2 or 3, wherein the heat treatment of the wafer in the second temperature range lasts for 1 hour or more.

5. A method as claimed in any preceding claim, wherein the heat treating of the wafer in the first temperature range takes place at 1050°C and lasts for 4 hours.

6. A method as claimed in any preceding claim, wherein the heat treating of the wafer in the second temperature range takes place at 650°C and lasts for 16 hours.

7. A method as claimed in any preceding claim, wherein active and/or passive elements of a semiconductor device are formed in the denuded zone.

8. A method as claimed in any one of claims 1 to 6, wherein an epitaxial layer is formed on the denuded zone, and active and/or passive element of a semiconductor device are formed on the epitaxial layer.

9. A method as claimed in any preceding claim, wherein the silicon wafer is a (100) single crystal CZ wafer made by the Czochralski method.

## Revendications

1. Procédé de fabrication d'une plaquette ou pastille de silicium comportant des microdéfauts internes destinés au piégeage d'impuretés, consistant en un traitement thermique de la pastille dans deux intervalles différents de température, le traitement thermique dans un premier de ces intervalles étant réalisé en atmosphère non oxydante, pour former une zone dénudée exempte de microdéfauts dans une couche superficielle de la pastille, et le traitement thermique dans le second de ces intervalles étant réalisé pour former à l'intérieur de la pastille des micro- défauts destinés au piégeage d'impuretés, caractérisé en ce que:

le premier intervalle de température est défini par les valeurs limites 950°C et 1300°C, le traitement thermique de la pastille dans le premier intervalle de température provoquant la diffusion d'oxygène hors de la couche superficielle de la pastille, et

le second intervalle de température est défini par les valeurs limites 600°C et 800°C, le traitement thermique suivant de la pastille dans le second intervalle de température provoquant la création d'une nucléation de précipités d'oxygène.

2. Procédé selon la revendication 1, caractérisé en ce que le traitement thermique de la pastille dans le premier intervalle de température dure 10 minutes ou plus.

3. Procédé selon l'une quelconque des revendications 1 et 2, caractérisé en ce que le traitement thermique de la pastille dans le premier intervalle de température dure moins de 70 heures.

4. Procédé selon l'une quelconque des revendications 1 à 3, caractérisé en ce que le traitement thermique de la pastille dans le second intervalle de température dure une heure ou plus.

5. Procédé selon l'une quelconque des revendications 1 à 4, caractérisé en ce que le traitement thermique de la pastille dans le premier intervalle de température a lieu à 1050°C et dure 4 heures.

6. Procédé selon l'une quelconque des revendications 1 à 5, caractérisé en ce que le traitement thermique de la pastille dans le second intervalle de température a lieu à 650°C et dure 16 heures.

7. Procédé selon l'une quelconque des revendications 1 à 6, caractérisé en ce que des éléments actifs et/ou des éléments passifs d'un dispositif semiconducteur sont constitués dans la zone dénudée.

8. Procédé selon l'une quelconque des revendications 1 à 6, caractérisé en ce qu'une couche épitaxiale est formée sur la zone dénudée, et en ce que des éléments actifs et/ou passifs d'un dispositif semiconducteur sont constitués sur la couche épitaxiale.

9. Procédé selon l'une quelconque des revendications 1 à 8, caractérisé en ce que la pastille de silicium est une pastille CZ monocristalline (100) fabriquée par le procédé de Czochralski.

## Patentansprüche

1. Verfahren zur Herstellung einer Siliziumscheibe mit getterfähigen inneren Mikrodefekten, bei welchem die Scheibe in zwei verschiedenen Temperaturbereichen mit Wärme behandelt wird, wobei die Wärmebehandlung im ersten Bereich in einer nicht oxidierenden Atmosphäre durchgeführt wird, um eine denudierte Zone frei von Mikrodefekten in einer Oberflächenschicht der Scheibe zu bilden, und die Wärmebehandlung in dem zweiten Bereich durchgeführt wird, um im Inneren der Scheibe getterfähige Mikrodefekte zu schaffen, dadurch gekennzeichnet, daß der erste Temperaturbereich die Grenzen 950°C und 1300°C hat und die Wärmebehandlung der Scheibe in dem ersten Temperaturbereich Sauerstoff aus der Oberflächenschicht der Scheibe diffundiert, und der zweite Temperaturbereich die Grenzen 600°C und 800°C hat und die folgende Wärmebehandlung der Scheibe in dem zweiten Temperaturbereich die Keimbildung von Sauerstoffausscheidung schafft.

2. Verfahren nach Anspruch 1, bei welchem die Wärmebehandlung der Scheibe in dem ersten Bereich 10 Minuten oder länger dauert.

3. Verfahren nach Anspruch 1 oder 2, bei welchem die Wärmebehandlung der Scheibe in dem ersten Temperaturbereich weniger als 70 Stunden dauert.

4. Verfahren nach Anspruch 1, 2 oder 3, bei welchem die Wärmebehandlung der Scheibe in dem zweiten Temperaturbereich 1 Stunde oder länger dauert.

5. Verfahren nach einem der vorhergehenden Ansprüche, bei welchem die Wärmebehandlung der Scheibe in dem ersten Temperaturbereich bei 1050°C stattfindet und 4 Stunden dauert.

6. Verfahren nach einem der vorhergehenden Ansprüche, bei welchem die Wärmebehandlung der Scheibe in dem zweiten Temperaturbereich bei 650°C stattfindet und 16 Stunden dauert.

7. Verfahren nach einem der vorhergehenden Ansprüche, bei welchem aktive und/oder passive Elemente einer Halbleitervorrichtung in der denudierten Zone gebildet werden.

8. Verfahren nach einem der Ansprüche 1 bis 6, bei welchem eine epitaktische Schicht auf der denudierten Zone gebildet wird und aktive und/oder passive Elemente der Halbleitervorrichtung auf der epitaktischen Schicht gebildet werden.

9. Verfahren nach einem der vorhergehenden Ansprüche, bei welchem die Siliziumscheibe eine (100)-Einkristall-CZ-Scheibe ist, welche nach dem Verfahren von Czochralski hergestellt ist.

FIG.1A

FIG.1B

FIG.2A

FIG.2C

FIG.2B

FIG.2D

FIG.3A

FIG.3C

FIG.3B

FIG.3D

1

**0 030 457**

FIG.4

• 1000°C, 0~64h Single annealing
○ 1270°c 2h+1000°c, 0~64h

2

FIG.5

- 650°c 0~64h    single annealing
○ 1270°c 2h + 650°c 0~64h

INTERSTITIAL OXYGEN CONTENT (×10¹⁷cm⁻³)

$INTERSTITIAL\ OXYGEN\ CONTENT\ (\times 10^{17} cm^{-3})$

0              10              100

ANNEALING TIME ( h )

3